# FASCICULE DE BREVET EUROPEEN

(11) **EP 3 802 920 B1**
(45) Date de publication et mention de la délivrance du brevet: **20.04.2022**
(21) Numéro de dépôt: 19724880.0
(22) Date de dépôt: 23.05.2019
(51) Int. Cl.: C25D 7/00, C25D 5/02, C25D 5/48, C25D 5/56, G04B 19/10, C25D 1/00

(54) **PROCEDE DE FABRICATION D'UN DECOR METALLIQUE SUR UN CADRAN ET CADRAN OBTENU SELON CE PROCEDE**
HERSTELLUNGSVERFAHREN EINES METALLDEKOREINSATZES AUF EINEM ZIFFERNBLATT, UND MIT DIESEM VERFAHREN ERZEUGTES ZIFFERNBLATT
METHOD FOR PRODUCING A METAL DECORATION ON A DIAL AND DIAL OBTAINED ACCORDING TO SAID METHOD

(30) Priorité: 28.05.2018 EP 18174638
(43) Date de publication de la demande: 14.04.2021
(73) Titulaire: The Swatch Group Research and Development Ltd, 2074 Marin (CH)
(72) Inventeur: LAFORGE, Elias, 2000 Neuchâtel (CH); SPRINGER, Simon, 3007 Bern (CH)
(74) Mandataire: ICB SA
(86) Numéro de dépôt international: PCT/EP2019/063357
(87) Numéro de publication internationale: WO 2019/228902

(56) Documents cités:
- EP-A1- 2 048 265
- EP-A1- 2 380 864
- CH-B1- 712 968
- JONGHO PARK ET AL: "Fabrication of metallic microstructure on curved substrate by optical soft lithography and copper electroplating", SENSORS AND ACTUATORS A: PHYSICAL, vol. 168, no. 1, 17 mars 2011 (2011-03-17) , pages 105-111, XP055502651, NL ISSN: 0924-4247, DOI: 10.1016/j.sna.2011.03.024

## Description

### Domaine de l'invention

La présente invention concerne un procédé de fabrication d'un décor métallique par une technologie de type LIGA. En particulier l'invention concerne un tel procédé pour la fabrication d'un cadran en céramique bombé avec un décor métallique s'adaptant de façon optimale sur le cadran. L'invention concerne également un tel cadran obtenu par ce procédé.

### Arrière-plan de l'invention

La technologie LIGA (Lithographie Galvanik Abformung) développée par W. Ehrfeld du Karlsruhe Nuclear Research Center, Allemagne) dans les années 80 s'est révélée intéressante pour la fabrication de microstructures métalliques de haute précision.

Dans son principe, la technique LIGA consiste à déposer sur un substrat conducteur ou revêtu d'une couche conductrice, une couche d'une résine photosensible, à effectuer à travers un masque correspondant au contour de la microstructure désirée une irradiation X au moyen d'un synchrotron, à développer, c'est-à-dire à éliminer par des moyens physiques ou chimiques les portions de la couche de résine photosensible non irradiées afin de définir un moule ayant le contour de la microstructure, à déposer galvaniquement un métal, typiquement du nickel, dans le moule en résine photosensible, puis à éliminer le moule pour libérer la microstructure.

La qualité des microstructures obtenues ne prête pas à critique, mais la nécessité de mettre en œuvre un équipement coûteux (synchrotron) rend cette technique peu compatible avec une production de masse de microstructures devant avoir un faible coût unitaire.

C'est pourquoi sur la base de ce procédé LIGA ont été développés des procédé analogues mais utilisant des résines photosensibles aux UV. Un tel procédé est notamment décrit dans le document CH 704 955, et comprend les étapes suivantes :
- se munir d'un substrat dont au moins une des faces est conductrice ;
- appliquer sur la face conductrice du substrat une couche de résine photosensible ;
- irradier la couche de résine à travers un masque définissant le contour de la microstructure désirée ;
- dissoudre les zones non irradiées de la couche de résine photosensible pour faire apparaître par endroit la face conductrice du substrat ;
- déposer galvaniquement des couches alternativement d'un premier métal et d'au moins un deuxième métal à partir de ladite face conductrice pour former un bloc atteignant sensiblement la surface supérieure de la résine photosensible, ledit bloc étant formé d'un empilement de couches des premier et deuxième métaux ;
- séparer par délamination la couche de résine et le bloc électrodéposé du substrat ;
- éliminer la couche de résine photosensible de la structure délaminée pour libérer la microstructure ainsi formée.

La réalisation de décors métalliques par dépôt galvanique selon ce procédé de l'art antérieur est faite sur une surface plane et sa mise en œuvre sur une pièce présentant surface bombée est bien plus complexe, la courbure de la pièce ne permettant pas de monter correctement les décors.

Des procédés similaires sont décris dans les documents XP055502651 (ONGHO PARK ET AL: "Fabrication of metallic microstructure on curved substrate by optical soft lithography and copper electroplating", SENSORS AND ACTUATORS A: PHYSICAL, vol. 168, no. 1, 17 mars 2011, pages 105-111) et CH 712 968 B1.

### Résumé de l'invention

La présente invention a pour but de remédier aux inconvénients susmentionnés ainsi qu'à d'autres encore en fournissant un procédé permettant de fabriquer des décors métalliques se conformant à la courbure des pièces à décorer.

La présente invention a également pour but de fournir un tel procédé qui soit simple et peu couteux à mettre en œuvre.

A cet effet l'invention a pour objet un procédé de fabrication d'au moins un décor métallique sur un substrat en matériau isolant présentant une surface bombée comprenant les étapes suivantes :
a) se munir du substrat et y déposer une couche de résine photosensible ;
b) irradier la couche de résine à travers un masque définissant le contour des décors désirés ainsi que des zones photopolymérisées et des zones non photopolymérisées ;
c) dissoudre les zones non irradiées de la couche de résine photosensible pour faire apparaître par endroit le substrat à l'emplacement des décors ;
d) déposer une première couche d'accroche et une deuxième couche électriquement conductrice via un dépôt en phase vapeur sur le substrat et les zones photopolymérisées ;
e) déposer galvaniquement une couche d'un métal ou d'un alliage métallique à partir de ladite deuxième couche conductrice pour former une couche atteignant au moins la surface supérieure de la résine photosensible ;
f) réaliser une étape de surfaçage et de polissage pour enlever le surplus de la couche déposée galvaniquement ;
g) éliminer la couche de résine restante par gravure plasma ;
h) éliminer les première et deuxième couches par une gravure humide.

Ce procédé permet donc la réalisation de pièces terminées en céramique présentant une surface bombée avec des décors métalliques en relief s'adaptant parfaitement à la surface.

Conformément à d'autres variantes avantageuses de l'invention :
- ladite première couche d'accroche est du type Ti, Ta, Cr ou Th ;
- ladite deuxième couche électriquement conductrice est choisie parmi : Au, Pt, Ag, Cr, Pd, TiN, CrN, ZrN ou Ni ;

### FEUILLE MODIFIÉE

- la première couche d'accroche présente une épaisseur comprise entre 30nm et 80nm ;
- la deuxième couche conductrice présente une épaisseur comprise entre 30nm et 80nm ;
- selon une variante du procédé, durant l'étape g), un premier métal est déposé à hauteur du moule, et avant l'étape i), le procédé comporte une étape h') de dépôt d'un deuxième métal recouvrant le premier métal déposé ;
- le substrat en matériau isolant, est un substrat non conducteur électriquement en céramique, en saphir, en nacre, en verre, en quartz, en diamant, en matière minérale (granit, marbre, ...), en polymères, en composites ou en émail.

Le procédé permet la fabrication d'un cadran bombé en matériau isolant présentant des décors métalliques, destiné à être rapporté sur une boîte de montre, et obtenu selon un procédé conforme à l'invention, les décorations étant des index, des appliques, et/ou un logo.

On comprend donc que le procédé de l'invention trouve une application particulièrement avantageuse pour la fabrication de pièces décoratives pour les pièces d'horlogerie.

### Description sommaire des dessins

D'autres caractéristiques et avantages de la présente invention ressortiront plus clairement de la description détaillée qui suit d'un exemple de réalisation d'un procédé selon l'invention, cet exemple étant donné seulement à titre purement illustratif et non limitatif, en liaison avec le dessin annexé sur lequel :

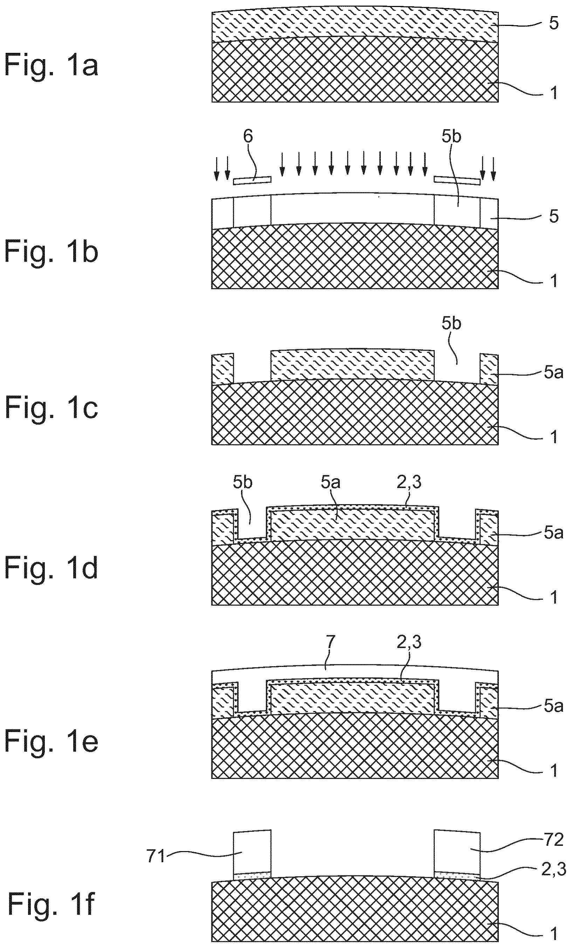

- les figures 1a à 1f illustrent les étapes de procédé d'un mode de réalisation de l'invention en vue de la réalisation d'un cadran muni d'appliques.

### Description détaillée des modes de réalisation préférés

Le substrat 1 utilisé dans l'étape a) du procédé selon l'invention est, par exemple, formé par un substrat en céramique, saphir, émail ou autre, et présentant une surface bombée. Lors de la première étape a) illustrée à la figure 1a on dépose une couche de résine

La résine photosensible 5 utilisée à l'étape a) du procédé selon l'invention est de préférence une résine de type négative à base d'époxy octofonctionnelle disponible chez Microchem sous la référence SU-8 et d'un photoinitiateur choisi parmi les sels de triarylsulfonium tels que ceux décrits dans le brevet US 4,058,401. Cette résine est susceptible d'être photopolymérisée sous l'action d'un rayonnement UV. On notera qu'un solvant qui s'est révélé approprié pour cette résine est le gammabutyrolactone (GBL).

Alternativement, une résine à base de phénolformaldéhyde de type Novolac en présence d'un photoinitiateur DNQ (DiazoNaphtoQuinone) peut également être utilisée.

La résine 5 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 1 µm et 500 µm, et plus préférentiellement entre 20 µm et 300 µm. Selon l'épaisseur désirée et la technique de dépôt utilisée la résine 5 sera déposée en une ou plusieurs fois.

La résine 5 est ensuite chauffée entre 80 et 95° C pendant une durée dépendant de l'épaisseur déposée pour évacuer le solvant. Ce chauffage sèche et durcit la résine.

L'étape b) suivante illustrée à la figure 1b consiste à irradier la couche de résine 5 au moyen d'un rayonnement UV à travers un masque 6 définissant le contour des décors souhaités et ainsi des zones photopolymérisées 5a et des zones non photopolymérisées 5b. Typiquement, cette irradiation UV est de 200 à 1'000 mJ.cm-2, mesurée à une longueur d'onde typique de 365 nm dépend de l'épaisseur de la couche et du type de résine sélectionnée.

Le cas échéant, une étape de recuit de la couche de résine 5 peut être nécessaire pour compléter la photopolymérisation induite par l'irradiation UV. Cette étape de recuit est effectuée de préférence entre 90°C et 95°C pendant 15 à 30 mn, voire plus selon l'épaisseur. Les zones photopolymérisées 5a deviennent insensibles à une grande majorité de solvants. Par contre, les zones non photopolymérisées pourront ultérieurement être dissoutes par un solvant.

L'étape c) suivante illustrée à la figure 1c consiste à développer les zones non photopolymérisées 5b de la couche de résine photosensible pour faire apparaître par endroit le substrat 1. Cette opération est réalisée par dissolution des zones non photopolymérisées 5b au moyen d'un solvant adéquat, par exemple choisi parmi le GBL (gammabutyrolactone) et le PGMEA (propylène glycol méthyle éthyle acétate). Un moule en résine photosensible photopolymérisées 5a présentant les contours d'un décor est ainsi réalisé.

Lors de l'étape d) du procédé on dépose par procédé physique en phase vapeur (PVD), une première couche d'accroche 2 et une deuxième couche conductrice 3, c'est-à-dire une couche apte à démarrer un dépôt métallique par voie galvanique. Typiquement, la couche d'accroche 2 est du type Ti, Ta, Cr ou Th, et présente une épaisseur comprise entre 30nm et 80 nm, et la couche conductrice 3 est du type Au, Pt, Ag, Cr, Pd, TiN, CrN, ZrN, Ni (figure 1a) et présente également une épaisseur comprise entre 30nm et 80 nm. Les première et deuxième couches d'accroche peuvent être déposées par tout autre moyen connu de l'homme du métier.

Alternativement, le substrat peut être réalisé en acier inoxydable ou en un autre métal apte à démarrer une réaction d'électroformage. Dans ce cas, les première et deuxième couches ne sont plus nécessaires. Dans le cas d'un substrat en acier inoxydable, ce dernier sera dégraissé avant usage, et l'arrière sera protégé avec du vernis ou une résine pour éviter le dépôt galvanique sur cette face arrière.

L'étape e) suivante illustrée à la figure 1e consiste à déposer galvaniquement dans les moules une couche d'un métal à partir de ladite couche conductrice 3 jusqu'à former une couche 7, atteignant préférentiellement au moins la hauteur des moules, l'épaisseur de la couche de métal étant comprise entre 1 µm et 500 µm, et plus préférentiellement entre 20 µm et 300 µm. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore ou le nickel-tungstène.

Les conditions d'électroformage, notamment la composition des bains, la géométrie du système, les tensions et densités de courant, sont choisis pour chaque métal ou alliage à électrodéposer selon les techniques bien connues dans l'art de l'électroformage (cf. par exemple Di Bari G.A. "electroforming" Electroplating Engineering Handbook 4th Edition rédigée par L.J. Durney, publié par Van Nostrand Reinhold Compagny Inc., N.Y. USA 1984 ).

Lors de l'étape f) du procédé on réalise un surfacage et/ou un polissage de la couche déposée galvaniquement lors de l'étape précédente pour enlever le surplus et obtenir une surface propre.

L'étape g) suivante consiste à éliminer la couche de résine 5a, la première couche d'accroche 2 et la deuxième couche conductrice 3 au moyen d'une gravure plasma et/ou d'une gravure humide, ce qui permet d'enlever ces couches sans endommager les blocs électrodéposés 71, 72.

A l'issue de cette étape g), on obtient un substrat 1 avec des blocs électrodéposés 71, 72 formant un décor sur le substrat 1, les première et deuxième couches 2, 3 étant encore présentes par endroit, sur le substrat après l'élimination de la résine restante.

A l'issue de cette étape, les pièces obtenues peuvent être nettoyées, et éventuellement reprises sur une machine-outil pour opérer des usinages ou une terminaison esthétique. A ce stade, les pièces peuvent être directement utilisées ou bien soumises à divers traitements décoratifs et/ou fonctionnels, typiquement des dépôts physiques ou chimiques.

Selon une alternative de l'invention, à l'étape e) on dépose galvaniquement une couche d'un premier métal tel que par exemple du nickel à partir de ladite couche conductrice pour former une couche d'une hauteur inférieure ou égale à la hauteur de la résine. L'étape suivante h) reste la même, et une étape additionnelle h') est effectuée au cours de laquelle on dépose galvaniquement une couche d'un autre métal ou alliage, par exemple précieux tel que de l'or par-dessus la couche du premier métal. Enfin, à l'étape g) la couche d'accroche 4 et les couches conductrice 3 et d'accroche 2 sont éliminées par au moins une gravure humide.

Une telle alternative est moins couteuse et plus facile à mettre en œuvre, la croissance du nickel étant plus facile à maitriser et moins couteuse qu'un métal précieux tel que l'or.

Le procédé de l'invention trouve une application particulièrement avantageuse pour la fabrication de pièces décoratives pour pièces d'horlogerie, et plus particulièrement pour des cadrans bombés en matière non conductrice, présentant des décorations métalliques à sa surface. Les décorations peuvent être des index, des appliques, des logos ou des noms de marque par exemple. Grâce à ce procédé, on peut munir un cadran bombé en matière non conductrice de tout type de décoration métallique s'adaptant parfaitement à la courbure de la surface du cadran bombé, avec un positionnement très précis, et en procédé multi-pièces donc économiquement intéressant.

## Revendications

1. Procédé de fabrication d'au moins un décor métallique sur un substrat (1) en matériau isolant présentant une surface bombée comprenant les étapes suivantes :
a) se munir du substrat (1) et y déposer une couche (5) de résine photosensible ;
b) irradier la couche (5) de résine à travers un masque (6) définissant le contour des décors désirés ainsi que des zones photopolymérisées (5a) et des zones non photopolymérisées (5b) ;
c) dissoudre les zones (5b) non irradiées de la couche de résine photosensible (5) pour faire apparaître par endroit le substrat (1) à l'emplacement des décors ;
d) déposer une première couche (2) d'accroche et une deuxième couche (3) électriquement conductrice via un dépôt en phase vapeur sur le substrat (1) et les zones photopolymérisées (5a) ;
e) déposer galvaniquement une couche d'un métal (7) ou d'un alliage métallique à partir de ladite deuxième couche électriquement conductrice (3) pour former au moins un bloc (71, 72) atteignant sensiblement la surface supérieure de la résine photosensible (5) ;
f) réaliser une étape de surfaçage et de polissage pour enlever le surplus de la couche déposée galvaniquement ;
g) éliminer la couche de résine (5) restante par gravure plasma ; et
h) éliminer les première et deuxième couches par une gravure humide.

2. Procédé selon la revendication 1, **caractérisé en ce que** ladite première couche d'accroche est du type Ti, Ta, Cr ou Th.

3. Procédé selon la revendication 1 ou 2, **caractérisé en ce que** ladite deuxième couche électriquement conductrice est choisie parmi : Au, Pt, Ag, Cr, Pd, TiN, CrN, ZrN ou Ni.

4. Procédé selon l'une des revendications précédentes, **caractérisé en ce que** la première couche d'accroche (2) présente une épaisseur comprise entre 30nm et 80nm.

5. Procédé selon l'une des revendications précédentes, **caractérisé en ce que** la deuxième couche conductrice (3) présente une épaisseur comprise entre 30nm et 80nm.

6. Procédé selon l'une des revendications précédentes, **caractérisé en ce que** :
- durant l'étape e), un premier métal ou un alliage métallique est déposé à hauteur du moule ;
- avant l'étape f), le procédé comporte une étape h') de dépôt d'un deuxième métal ou alliage métallique recouvrant le premier métal ou alliage métallique déposé.

7. Procédé selon l'une des revendications précédentes, **caractérisé en ce que** le substrat (1) en matériau isolant, est un substrat en céramique, en saphir, en nacre, en verre, en quartz, en diamant, en matière minérale, en polymères, en composites, en verre ou en émail.

## Patentansprüche

1. Verfahren zum Herstellen mindestens eines Metalldekors auf einem Substrat (1) aus Isoliermaterial mit einer gewölbten Oberfläche, das die folgenden Schritte umfasst:
a) Bereitstellen des Substrats (1) und darauf Auftragen einer Schicht (5) aus einem lichtempfindlichen Harz;
b) Bestrahlen der Harzschicht (5) durch eine Maske (6), die die Kontur der gewünschten Verzierungen sowie photopolymerisierte Bereiche (5a) und nicht photopolymerisierte Bereiche (5b) definiert;
c) Auflösen der nicht bestrahlten Bereiche (5b) der lichtempfindlichen Harzschicht (5), um am Ort der Verzierungen das Substrat (1) stellenweise freizulegen;
d) Ablagern einer ersten anhaftenden Schicht (2) und einer zweiten elektrisch leitenden Schicht (3) über eine Dampfphasenabscheidung auf dem Substrat (1) und den photopolymerisierten Zonen (5a);
e) galvanische Abscheidung einer Schicht aus einem Metall (7) oder einer Metalllegierung ausgehend von der zweiten elektrisch leitenden Schicht (3), um mindestens einen Block (71, 72) zu bilden, der im Wesentlichen die obere Oberfläche des lichtempfindlichen Harzes (5) erreicht;
f) Durchführen eines Oberflächenbehandlungs- und Polierschrittes, um den Überschuss an der galvanisch abgeschiedenen Schicht zu entfernen;
g) Entfernen der verbleibenden Harzschicht (5) durch Plasmaätzen; und
h) Entfernen der ersten und der zweiten Schicht durch Nassätzen.

2. Verfahren nach Anspruch 1, **dadurch gekennzeichnet, dass** die erste anhaftende Schicht vom Typ Ti, Ta, Cr oder Th ist.

3. Verfahren nach Anspruch 1 oder 2, **dadurch gekennzeichnet, dass** die zweite elektrisch leitende Schicht ausgewählt ist aus: Au, Pt, Ag, Cr, Pd, TiN, CrN, ZrN oder Ni.

4. Verfahren nach einem der vorhergehenden Ansprüche, **dadurch gekennzeichnet, dass** die erste anhaftende Schicht (2) eine Dicke zwischen 30 nm und 80 nm aufweist.

5. Verfahren nach einem der vorhergehenden Ansprüche, **dadurch gekennzeichnet, dass** die zweite leitende Schicht (3) eine Dicke zwischen 30 nm bis 80 nm aufweist.

6. Verfahren nach einem der vorhergehenden Ansprüche, **dadurch gekennzeichnet, dass**:
- während des Schrittes e) ein erstes Metall oder eine erste Metalllegierung bis zur Höhe der Form abgelagert wird;
- das Verfahren vor dem Schritt f) einen Schritt h') des Ablagerns eines zweiten Metalls oder einer zweiten Metalllegierung, das bzw. die das abgelagerte erste Metall oder die abgelagerte erste Metalllegierung bedeckt, umfasst.

7. Verfahren nach einem der vorhergehenden Ansprüche, **dadurch gekennzeichnet, dass** das Substrat (1) aus isolierendem Material ein Substrat aus Keramik, Saphir, Perlmutt, Glas, Quarz, Diamant, Mineralstoff, Polymeren, Verbundstoffen, Glas oder Emaille ist.

## Claims

1. Method for producing at least one metal decoration on a substrate (1) made of insulating material having a curved surface comprising the steps of:
a) providing the substrate (1) and depositing thereon a photosensitive resin layer (5);
b) irradiating the resin layer (5) through a mask (6) defining the contour of the desired decorations as well as of the photopolymerised areas (5a) and of the non-photopolymerised areas (5b);
c) dissolving the non-irradiated areas (5b) of the photosensitive resin layer (5) in order to show in places the substrate (1) at the location of the decorations;
d) depositing a first adhesion layer (2) and a second electrically conductive layer (3) via a vapour deposition on the substrate (1) and the photopolymerised areas (5a);
e) galvanically depositing a layer of a metal (7) or of a metal alloy from said second electrically conductive layer (3) in order to form at least one block (71, 72) substantially reaching the upper surface of the photosensitive resin (5);
f) performing a step of surfacing and polishing in order to remove the surplus of the galvanically deposited layer;
g) eliminating the remaining resin layer (5) by plasma etching; and
h) eliminating the first and second layers by a wet etching.

2. Method according to claim 1, **characterised in that** said first adhesion layer is of the Ti, Ta, Cr or Th type.

3. Method according to claim 1 or 2, **characterised in that** said second electrically conductive layer is chosen from: Au, Pt, Ag, Cr, Pd, TiN, CrN, ZrN or Ni.

4. Method according to one of the preceding claims, **characterised in that** the first adhesion layer (2) has a thickness between 30 nm and 80 nm.

5. Method according to one of the preceding claims, **characterised in that** the second conductive layer (3) has a thickness between 30 nm and 80 nm.

6. Method according to one of the preceding claims, **characterised in that**:
- during step e), a first metal or a metal alloy is deposited at the height of the mould;
- before step f), the method comprises a step h') of depositing a second metal or metal alloy covering the first metal or metal alloy deposited.

7. Method according to one of the preceding claims, **characterised in that** the substrate (1) made of insulating material, is a substrate made of ceramic, sapphire, mother-of-pearl, glass, quartz, diamond, mineral material, polymers, composites, glass or enamel.
